# EUROPEAN PATENT APPLICATION

(11) **EP 4 811 359 A1**
(43) Date of publication of application: **23.09.2026**
(21) Application number: 26163842.3
(22) Date of filing: 11.03.2026
(51) Int. Cl.: G11C 7/10, G11C 7/12, G11C 8/06, G11C 8/10, G11C 8/12, G11C 7/18

(54) **EFFICIENT DATA TRANSFERS IN MEMORY CIRCUITS**

(30) Priority: 18.03.2025 US 202563774097 P; 28.01.2026 US 202619463063
(71) Applicant: Samsung Electronics Co., Ltd., Suwon-si, Gyeonggi-do 16677 (KR)
(72) Inventor: SONG, Daesik, San Jose, CA, 95134 (US)
(74) Representative: Kuhnen & Wacker Patent- und Rechtsanwaltsbüro PartG mbB

(57) **Abstract**

A system and a method for a data transfer in a memory circuit are disclosed. The memory circuit includes a data transfer circuit (425), a column select, CS, decoder (412), and an access decoder (414). The data transfer circuit (425) includes a select switch configured to connect a local input/output, LIO, line to a bit line, BL, of a memory cell in a memory section (420) and a data switch configured to route data between LIO line and a global input/output, GIO, line connected to a data bus in response to an access operation. The CS decoder (412) is configured to decode a first part of a column address, CA, of the access operation to generate a CS signal that enables the select switch. The access decoder (414) is configured to decode a second part of the CA (430) and an access signal to generate an access enable, AE, signal that enables the data switch.

## Description

### TECHNICAL FIELD

The disclosure generally relates to memory devices. More particularly, the subject matter disclosed herein relates to data transfers in memory circuits.

### BACKGROUND

The present background section is intended to provide context only, and the disclosure of any concept in this section does not constitute an admission that said concept is prior art.

Three-dimensional (3D) memory configurations have been increasingly popular. 3D memory devices, such as vertically stacked dynamic random-access memory (VSDRAM), include memory cells that are stacked vertically to increase storage density. The additional vertical direction poses considerations in arranging the memory cells in the 2D plane to accommodate the desired density. When the memory cells in the 2D are organized to distribute a block of data having an active word line (WL) into sections, prefetched data may also be distributed equally to the sections. For reliability, error-correcting code (ECC) data are often included with the data transferred across the sections.

Existing techniques for data transfers in memory arrays with distributed WLs have a number of drawbacks. The existing addressing decode scheme may cause duplication of storage for the ECC-encoded data. This may lead to increased storage areas.

The above information disclosed in this Background section is only for enhancement of understanding of the background of the disclosure and therefore it may contain information that does not constitute prior art.

### SUMMARY

To overcome these issues, systems and methods are described herein for a technique of data transfer in a memory circuit. The invention is set out in the appended claims. According to embodiments a memory circuit includes a data transfer circuit, a column select (CS) decoder, and an access decoder. The data transfer circuit includes a select switch configured to connect a local input/output (LIO) line to a bit line (BL) of a memory cell in a memory section and a data switch configured to route data between LIO line and a global input/output (GIO) line connected to a data bus in response to an access operation. The CS decoder is configured to decode a first part of a column address (CA) of the access operation to generate a CS signal that enables the select switch. The access decoder is configured to decode a second part of the CA and an access signal to generate an access enable (AE) signal that enables the data switch.

In some embodiments, the access operation includes a write operation and a read operation. In some embodiments, the memory section is selected by an active word line (WL). In some embodiments, the data transfer circuit further includes a bit line sense amplifier (BLSA) connected to the BL to sense charge from the memory cell. The BL may be connected to the memory cell and the BLSA may be connected to the BL. In some embodiments, the data switch includes a write switch and a read switch. The write switch is configured to turn on in a write operation to transfer the data from the GIO line to the LIO line. The read switch is configured to turn on in a read operation to transfer the data from the LIO line to the GIO line. In some embodiments, the first part, the second part, and the column address have a first bit width, a second bit width, and an address bit width, respectively. The address bit width is equal to a sum of the first bit width and the second bit width. In some embodiments, the data includes an error-correction code (ECC) and prefetch data. Each of the LIO, GIO, and BL lines may include differential signals. The memory section may be on a two-dimensional (2D) stack in a three-dimensional (3D) memory circuit.

### BRIEF DESCRIPTION OF THE DRAWINGS

In the following section, the aspects of the subject matter disclosed herein will be described with reference to exemplary embodiments illustrated in the figures, in which:
FIG. 1 is a block diagram illustrating a system that utilizes a 3D memory circuit according to an embodiment.
FIG. 2 is a diagram illustrating a 3D memory circuit that utilizes an efficient data transfer mechanism according to an embodiment.
FIG. 3 is a diagram illustrating an organization scheme for the memory circuit according to an embodiment.
FIG. 4A is a diagram illustrating a data transfer structure in the memory circuit according to an embodiment.
FIG. 4B is a diagram of an example illustrating an address decoding scheme according to an embodiment.
FIG. 5 is a diagram illustrating a structure of the memory circuit having distributed active WLs according to an embodiment.
FIG. 6 is a diagram illustrating a data switch according to an embodiment.
FIG. 7 is a flow chart illustrating a process of accessing a memory circuit according to an embodiment.
FIG. 8 is a flow chart illustrating a process of transferring data according to an embodiment.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments.

Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other. Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements. In the following, figures depicting various components, structures, interconnections, configurations, and steps of fabrication, are mainly for illustrative purposes. They are not intended to describe these elements accurately. A cross-sectional representation may be used to refer to a 3D block in a 3D structure. In some cases, relevant parts in a figure are shown clearly while other parts are shown with less sharpness or clarity to avoid confusion and improve contrast and clarity. These parts may be referenced in earlier figures and therefore do not need to be described again. These parts may also have little relationship with the part(s) being described. In addition, the shading of the parts in the figures may not have a consistent design and may be changed to maintain clarity and contrast in the figures. For example, part A may have a light shading in Fig. X but may be heavily shaded in Fig. Y. Moreover, as mentioned above, components in a figure may not be drawn with proper scales.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items. The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Many applications, especially applications in Artificial Intelligence (AI) and signal processing, require a vast storage capacity and high throughput computations. To satisfy these needs, highly dense memory circuits in 3D are developed. A typical 3D dynamic random-access memory (DRAM) device may stack multiple layers of memory cells vertically. Bit lines (BLs) and word lines (WLs) may be arranged vertically to access cells in different layers. BLs and WLs are conductive elements that are used to select memory cells which may be arranged in a row-and-column array.

In the following, a system and a method for transferring data in a memory circuit are disclosed. The memory circuit includes a data transfer circuit, a column select (CS) decoder, and an access decoder. The data transfer circuit includes a select switch configured to connect a local input/output (LIO) line to a bit line (BL) of a memory cell in a memory section and a data switch configured to route data between LIO line and a global input/output (GIO) line connected to a data bus in response to an access operation. The CS decoder is configured to decode a first part of a column address (CA) of the access operation to generate a CS signal that enables the select switch. The access decoder is configured to decode a second part of the CA and an access signal to generate an access enable (AE) signal that enables the data switch.

The access operation includes a write operation and a read operation. The memory section is selected by an active word line (WL). In some embodiments, the data transfer circuit further includes a bit line sense amplifier (BLSA) connected to the BL to sense charge from the memory cell. The BL is connected to the memory cell and the BLSA is connected to the BL. In some embodiments, the data switch includes a write switch and a read switch. The write switch is configured to turn on in a write operation to transfer the data from the GIO line to the LIO line. The read switch is configured to turn on in a read operation to transfer the data from the LIO line to the GIO line.

In some embodiments, the first part of the CA, the second part of the CA, and the column address have a first bit width, a second bit width, and an address bit width, respectively. The address bit width is equal to a sum of the first bit width and the second bit width. In some embodiments, the data includes an error-correction code (ECC) and prefetch data. Each of the LIO, GIO, and BL lines is configured to carry differential signals. The memory array is on a two-dimensional (2D) stack in a three-dimensional (3D) memory circuit.

Accordingly, by having two different parts of the column address to select or enable these two different memory functions-access to the memory cells and transfer between internal bus and internal I/O lines-in the memory sections, the data transfer is efficient and avoids duplications when the ECC is combined with the message to be distributed over the sections having active WLs.

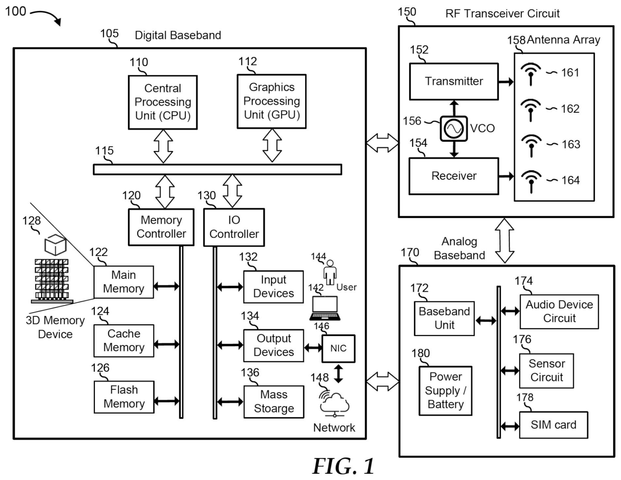

FIG. 1 is a block diagram illustrating a system that utilizes a 3D memory circuit according to an embodiment. The system 100 includes a digital baseband circuit 105, a radio frequency (RF) transceiver circuit 150, and an analog baseband circuit 170. The system 100 may represent a digital system or a mobile system. When the system 100 is used as a digital system without mobile circuitry, the RF transceiver circuit 150, and the analog baseband circuit 190 are not used. In addition, when the system 100 is used as a mobile device, many of the digital devices are scaled back and some devices may not be available.

The digital baseband circuit 105 includes central processing unit (CPU) 110, a graphics processing unit (GPU) 112, a memory controller 120, and an IO controller 130. The system 100 may include more or less than the above components. In addition, a component may be integrated into another component. The integration may be partial and/or overlapped. For example, the memory controller 120 and the I/O controller 130 may be integrated into one single controller.

The CPU 110 is a programmable device that may execute a program or a collection of instructions to carry out a task. It may be a host that controls or manages other processors or devices. In particular, the CPU 110 may include applications programming interfaces (APIs), applications, or drivers that are executed by the CPU 110 to perform specified tasks. The CPU 110 may be a general-purpose processor, a digital signal processor, a microcontroller, or a specially designed processor. It may include a single core or multiple cores. Each core may have multi-way multi-threading. The CPU 110 may have simultaneous multithreading feature to further exploit the parallelism due to multiple threads across the multiple cores. In addition, the CPU 110 may have internal caches at multiple levels.

The GPU 112 is a specialized processor designed to perform computationally intensive tasks such as image analysis, graphics rendering, and neural computations. In addition, the GPU 112 may be designed with parallel processing capability, suitable for parallel computations in artificial intelligence (AI) applications including machine learning (ML), large language model (LLM), and neural networks (NN). The GPU 112 may be used to accelerate training and running AI models. It may include multiple computational accelerators or tensor cores which are optimized for basic AI computations such as matrix multiply-accumulate operations

The CPU 110 and the GPU 112 communicate with other devices in the system via a bus 115. The bus 115 may include address, data, control, timing, and power signals. The bus 115 may be any suitable bus connecting the CPU 110 and/or the GPU 112 to other devices. For example, the bus 115 may be a Direct Media Interface (DMI). The bus 115 may also include other custom buses such as a bus for the interface to the analog section when the system 100 is used as a mobile device. Additional devices or bus interfaces may be available for interconnections and/or expansion. Some examples may include the Peripheral Component Interconnect Express (PCle) bus, the Universal Serial Bus (USB), etc.

The memory controller 120 controls memory devices such as a main memory 122, a cache memory 124, and a flash memory 126. The main memory 122 includes random access memory (RAM) including static RAM (SRAM) and dynamic RAM (DRAM) and/or the read-only memory (ROM) and other types of memory. The DRAM may include Synchronous DRAM (SDRAM), Double Data Rate SDRAM (DDR SDRAM) with variations (e.g., DDR2, DDR3, DDR4, DDR5, and DDR6). The main memory 122 may store instructions or programs, loaded from a mass storage device, that, when executed by the CPU 110, cause the CPU 110 to perform operations for a specified task. It may also store data used in the operations. The ROM may be a solid-state drive (SSD) and include instructions, programs, constants, or data that are maintained whether it is powered or not. The instructions or programs may correspond to the functionalities described in the following. In one embodiment, the main memory 122 includes a 3D memory device or circuit 128 such as VSDRAM or any other memory devices that have memory cells that are stacked vertically to increase storage density. The 3D memory device 128 may have an organization of memory arrays to have distributed active WLs with efficient data routing.

The I/O controller 130 controls input devices 132, output devices 134, and mass storage 136. The input devices 132 may include a keyboard, a mouse, an image sensor or camera, a game console, and a microphone. Other input devices may also be available such as stylus, joystick, scanner, and light pen. The input devices may also have a user interface to interface to a computer or laptop 142 and/or a user 144. The output devices 134 may include a printer, a monitor or screen, a headset, and a multi-monitor set. When used as a computing device without mobile features, the monitor is a high-resolution display. For games and other multi-display mode, the multi-monitor set provides high-resolution with multiple monitors (e.g., three monitors). When used for mobile communication, the screen provides the primary interface for the user to navigate, access various applications and perform tasks. The screen may use organic light-emitting diode (OLED) (super retina) display with multi-touch or haptic touch feature. The mass storage 136 may include CD-ROM, hard disk, and solid-state drives (SSDs). The digital baseband circuit 105 also has a network interface card (NIC) 146 which provides an interface to a network and wireless medium 148.

The RF transceiver circuit 150 includes a transmitter 152, an antenna array 158, a voltage-controlled oscillator (VCO) 156, and a receiver 154. The RF circuit 150 operates at a high GHz frequency band to accommodate modern cellular equipment such as the fifth generation (5G) wireless.

The transmitter 152 transmits the digital baseband data to the antenna array 158. The transmitter 152 may include a digital-to-analog converter (DAC), an automatic gain controller (AGC), an intermediate frequency (IF) circuit, a mixer, an RF circuit, and a power amplifier (PA). Other components may include filters, amplifiers, multiplexers, coaxial cables, phase shifters, etc. The DAC converts digital data f₁ into an analog signal f₂. The AGC automatically adjusts the signal amplitude of f₂ to generate a signal f₃ to maintain a consistent strength level in a dynamic and changing environment. The IF circuit performs intermediate frequency processes such as filtering to generate a signal f₄. The mixer converts the frequency of the signal f₄ to another frequency. This is done by mixing the signal f₄ with a signal vₜ from the VCO 156. Mixing here refers to frequency modulation which translates the signal f₄ to a signal f₅ at a different frequency. For transmitter, the translated frequency is higher than the frequency of f₄. The conversion is called up-conversion. For 5G communication, the frequency range may include low-band (below 1 GHz), mid-band (1 GHz to 6 GHz), and high-band (24 GHz to 53 GHz or higher). The resulting signal f₅ then goes through various radio frequency processes performed by the RF circuit such as highpass filtering to produce a signal f₆. The signal f₆ is strengthened and amplified by the PA to produce a signal f₇. The signal f₇ then goes to the antenna array 158 to be transmitted to an appropriate destination and medium (e.g., base station). The antenna array 158 uses beam forming to focus radio waves from f₇ in a desired direction. The antenna array 158 may be used for both transmitting and receiving. On receiving, the antenna array 158 receives an RF signal and sends it to the receiver 154. The number of antennas in the antenna array 158 depends on the desired coverage. The antenna array 158 may include antennas 161, 162, 163, and 164 configured to operate with 5G communication, Gigabit Long Term Evolution (LTE), Wi-Fi (e.g., 2.4 GHz, 5 GHz, and 6Ghz), and Bluetooth, respectively. The number of antennas may be more or less than the above.

The VCO 156 couples multiple in-phase oscillators together to provide low phase noise oscillation. It generates signals vₜ and vᵣ to the mixers at specified frequencies. It may include multiple oscillation core circuits (or VCO cores) to provide high-frequency periodic signals.

The receiver 154 processes the received signal r₇ in a manner reverse from the transmitter 152. It may include a low noise amplifier (LNA), an RF circuit, a mixer, an IF circuit, an AGC, and an analog-to-digital converter (ADC). The receiver 154 may include more or less than the above components. The LNA amplifies the weak signal r₇ while maintaining a good signal-to-noise ratio (SNR) to produce a signal r₆ for further processing. The signal r₆ is next processed by the RF circuit such as band-pass filtering to provide a signal r₅. Additional filtering may be performed in the next stages. The signal r₅ is then mixed with the signal vᵣ from the VCO 156 to down convert the signal r₅ to a signal r₄ at an appropriate low frequency. Like the mixer in the transmitter 152 but with a reverse operation, the mixer in the receiver performs frequency modulation to translate the high frequency signal r₅ to a low frequency signal r₄. The signal r₄ goes through IF processing such as additional filtering by the IF circuit to produce a signal r₃. The AGC amplifies and strengthens the signal and generates a signal r₂. The ADC converts the analog signal r₂ into digital data r₁ which will be processed by the CPU 110.

The analog baseband circuit 170 provides analog processing for various components. It handles processing of signals and data between the digital baseband circuit and the RF transceiver circuit 150. It may include analog and digital components to perform various tasks including modulation/demodulation, controlling the RF transceiver circuit 150, special circuitry for 3G, 4G/LTE, Bluetooth, and 5G communication. It may also interface with an audio device circuit 174, a sensor circuit 176, a Subscriber Identity Module (SIM) card 178, and other components. The audio device circuit 174 may include operational blocks to process audio signals and perform audio-related functions such as filtering, correlation, speech recognition. It may include digital circuits to perform Fast Fourier Transform (FFT) to perform signal processing in the frequency domain. The sensor circuit 176 may include a variety of sensors such as proximity, ambient light, motion (accelerometer and gyroscope, compass, barometer, fingerprint sensor for touch identification (ID), image sensors for face ID, light detection and ranging (LiDAR) scanner, etc. The SIM card 178 is a small, removable chip that stores the user's phone number and carrier information, allowing the device to connect to a cellular network.

The power supply and battery circuit 180 provides power and battery backup supply to the entire system. It may include a charger to charge the battery. The battery may be a rechargeable battery, such as a Lithium-Ion battery. Power management may be performed by application software and circuits to provide low power mode and performance management.

The system 100 is an example that illustrates the role of 3D memory devices in a laptop, desktop or mobile environment. In many cases, the environment of the applications adds additional requirements including low power consumption, reliable signal integrity, fault-tolerance, and reliable operations in extreme conditions including heat and tight space. Examples of other applications that would benefit from 3D memory devices or circuits include mobile communication (e.g., smart phones, base stations, user equipment), cameras, vehicles, entertainment (e.g., games, multimedia, music, movies), technical designs (e.g., animation, graphics), medical (e.g., visualization, medical imaging), robotics, drones, automatic test equipment, audio processing, speech synthesizer, video and image analysis, vision, automatic face recognition, artificial intelligence (AI) applications, and data centers.

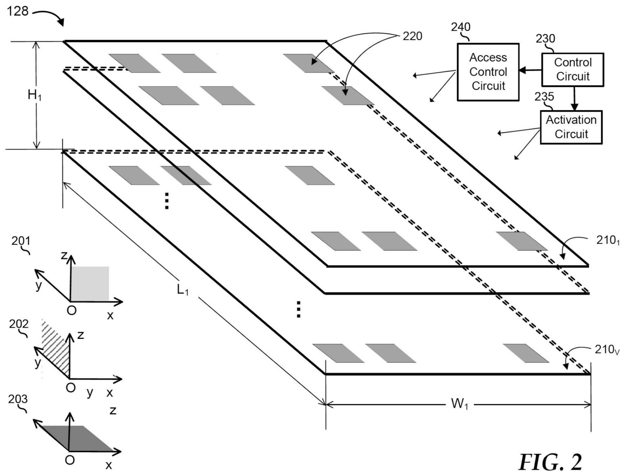

FIG. 2 is a diagram illustrating a 3D memory circuit that utilizes an efficient data transfer mechanism according to an embodiment. The 3D memory circuit 128 includes a 3D structure having planes defined according to a coordinate system of Ox, Oy, and Oz 201, 202, and 203. The planes 201, 202, and 203 refer to an xOz plane, an yOz, and an xOy plane, respectively. For clarity, only relevant components are shown. In addition, component indices may not be used and components with different indices are shown without indices. The 3D memory circuit 128 includes V two-dimensional (2D) memory array planes 210₁ to 210_{V}, where V is a positive integer, a control circuit 230, an activation circuit 235, and an access control circuit 240.

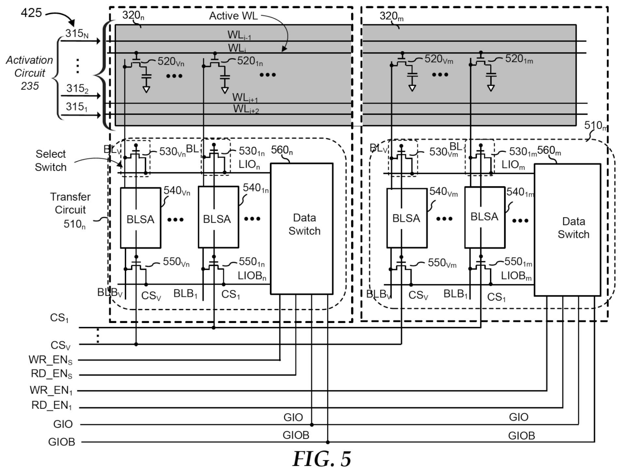

The V memory array planes 210₁ to 210_{V} are stacked vertically in the vertical direction Oz. Each of the memory array planes includes a 2D memory array having elements or circuits 220 arranged in rows and columns on a rectangular plane such as the plane xOy 203. Each array may have a length dimension L₁ which refers to the number of rows and a width dimension W₁ which refers to the number of columns. The number of memory array planes that are stacked vertically is a height dimension H₁. For a desired density, the dimensions L₁, W₁, and H₁ may be configured accordingly. For example, at least one of the row dimension L₁ or the column dimension W₁ is proportional to the height dimension H₁. Each of the circuits 220 may include a matrix of memory cells and a transfer circuit. The circuit 220 will be described with more details with reference to FIG. 5.

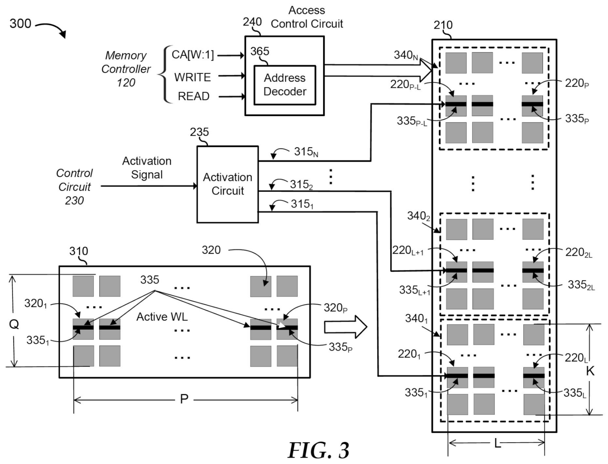

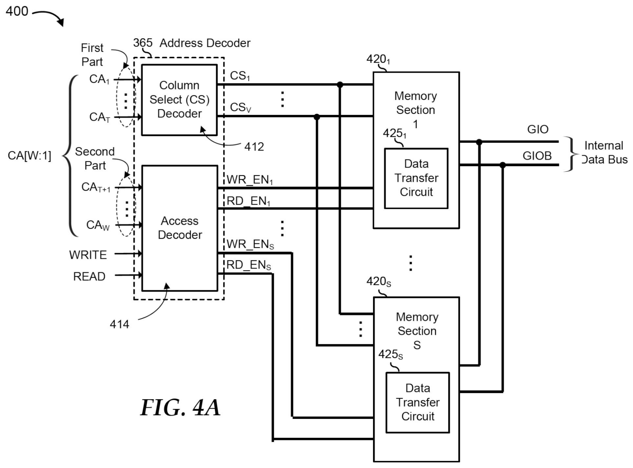

The control circuit 230 includes control logic to general control signals or to perform various control functions with respect to the operations of the memory array plane 210. The control signals may include various timing signals and command signals to initiate, maintain, or terminate operations. One particular operation is activation. Activation is a common operation in DRAM. In a typical scenario, activation opens a row of memory cells and transfers the charges in the memory cells into the associated sense amplifiers to prepare for memory read/write cycles. The control circuit 230 may generate an activation signal to the activation circuit 235. The activation circuit 235 includes logic circuits to generate activation commands to the memory array planes 210. The activation commands may trigger, initiate, or terminate the activation operation from the internal activation circuits in the memory array planes 210. The activation commands are further described with reference FIG. 3 and FIG. 5. The access control circuit 240 receives the column address (CA) from the memory controller 120 and generates the decoded address signals to the memory array 210. The access control circuit 240 will be described further in FIG. 4A.

FIG. 3 is a diagram illustrating an organization scheme 300 for the memory circuit according to an embodiment. The scheme 300 involves an array 310 and the array 210 shown in FIG. 2 without the subscript index, the activation circuit 235, and the access control circuit 240 shown in FIG. 2. FIG. 3 illustrates the mapping or organizations scheme for the memory circuit. The illustrative scheme focuses on how the memory circuit is organized in terms of general architecture. Accordingly, specific description of detailed circuits is omitted.

The array 310 is a typical array organization without using the active WL distributive scheme. The array 310 may be an array of matrices 320 arranged in rows and columns in a 2D organization having Q rows and P columns. Each matrix 320 includes a structure of a memory circuit WL, BL, and switching circuits. The array 310 includes a row of elements or circuits 320, to 320_{P} which contain parts of an active WL 335. The active WL 335 is a WL that is activated in response to an activation. The WL 335 may be divided into equal segments 335₁ to 335_{P} in the elements or circuits 320₁ to 320_{P}, respectively. The activation is the process of accessing a specific row of memory cells in a particular bank. A bank is a subdivision of a memory array. The activation involves sensing the charges stored in the memory cells at the selected row using bit line sense amplifiers (BLSAs) for charge sensing and temporary storage. Activation, therefore, prepares the memory array to be accessed (read or write) quickly. The array 310 is organized into the array 210. FIG. 3 illustrates how this organization is performed. The elements or circuits 320₁ to 320_{P} remain the same but their locations or placements in the array 310 are changed and therefore their corresponding labels are also changed. Accordingly, we have the following mappings: array 310 → array 210, circuits 320₁ to 320_{P} → 220₁ to 220_{P}. The labels for the WLs 335₁ to 335_{P} remain the same.

The array 210 is the array having the organization of distributed WLs across sections. It is equally distributed or organized into N sections 340, to 340_{N}. The N sections 340₁ to 340_{N} form a section set. Each section having a row dimension K and a column dimension L. K may be any suitable positive integer. For simple mapping and controlling, K = Q. The dimensions K and L, and N are positive integers. The active WL 335 is divided into N segments distributed over the entire N sections 340₁ to 340_{N}. In other words, the first segment includes elements/circuits 335₁ to 335_{L} which reside in the first section 340₁, the second segment includes elements/circuits 335_{L+1} to 335_{2L} which reside in the second section 340₂, and so on. The last segment includes elements/circuits 335_{P-L} to 335_{P} which reside in the last section 340_{N.} For example, suppose P = 2048, L = 128, K = Q = 512. Then, the number of segments is N = PQ/LK = 16. Each section 340ⱼ (j=1, ..., 16) is organized as KxL or 512 rows and 128 columns. The first section 340₁ contains the first segment including elements/circuits 335₁ to 335₁₂₈. The second section 340₂ contains the second segment including elements/circuits 335₁₂₉ to 335₂₅₆. The last section 340₁₆ contains the last segment including elements/circuits 335₁₉₂₀ to 335₂₀₄₈. Each segment has a length (or size) of L, which means it is connected to L circuits or elements 220. When the WL 335 is activated, the N segments including elements/circuits 335₁ to 335_{P} are all activated. The arrangement does not change the activation operation. The memory circuit, therefore, functions normally. The benefits include the flexibility of the arrangement which may lead to optimization of the layout. For example, in one embodiment, at least one of the row dimension or the column dimension is proportional to the height dimension. This is to maintain the memory density at the same level. In addition, the total required prefetch data are evenly distributed to each section.

The activation circuit 235 is configured to activate, in response to an activation, N segments of a word line (WL) in the N sections, respectively. The N segments include elements/circuits 335₁ to 335_{P} as above. The activation (ACT) is a signal coming from the control circuit 230, shown in FIG. 2, which may be part of the memory controller 120 in FIG. 1. In some embodiments, the control circuit 230 sends the ACT command using the standardized protocol in datasheet, or Joint Electron Device Engineering Council (JEDEC) spec, then the memory device generates the ACT signal internally to control the activation circuit in the memory device. The activation circuit 235 is configured to activate, in response to an activation, N segments of a word line (WL) in the N sections, respectively. Each of the N segments being connected to L circuits or elements 220. The activation circuit 350 may be a decoder to decode the activation signal from the controller 120 to N activating signals 315₁ to 315_{N} that are distributed to the N sections 340₁ to 340_{N}.

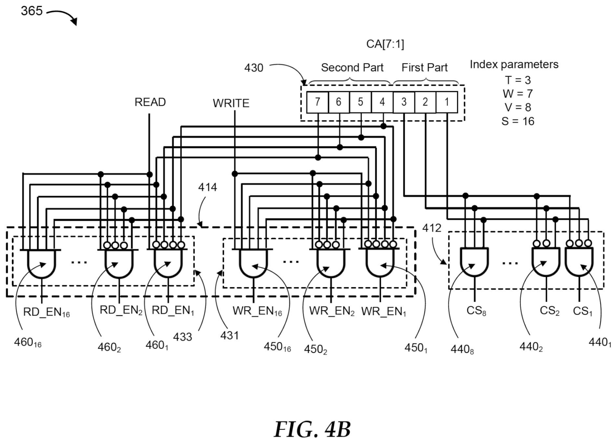

The access control circuit 240 is configured to access the memory cells in the array 210. The access includes a write access and a read access. The access typically involves data transfers between the internal data bus and the memory cells in the memory circuit. The access control circuit 240 provides efficient data transfers by avoiding duplication of data when accessing the array having distributed active WLs. The access control circuit 240 receives the column address CA[W:1] having a bit width of W bits, a WRITE signal to indicate a write operation or cycle, and a READ signal to indicate a read operation cycle. The access control circuit 240 includes logic circuits, temporary storage, and an address decoder 365. The address decoder 365 will be described in FIG. 4A and FIG. 4B.

In applications involving ECC, the ECC is merged with the message data to be sent. An example is the Hamming code. For high reliability data, the Hamming parity code is often used for error detection and single-bit correction. For a single-bit error correction, the size Q of the ECC depends on the size M of the message according to the following inequality:${2}^{Q} \geq M + Q + 1$

When M = 128 bits = 16 Bytes, the typical size of prefetch data, the size of the ECC is 8 for a total data size of 128 + 8 = 136 bits. When the memory organization with distributed active WL segments, the data transfer that avoids duplication for the parity data storage aims at decoding the column address in two distinct steps or processes: one or the column select and one for the data select.

FIG. 4A is a diagram illustrating a data transfer structure 400 in the memory circuit according to an embodiment. The data transfer structure 400 includes S memory sections 420₁ to 420_{S} and the address decoder 365 shown in FIG. 3. The data transfer structure 400 may include more or less than the above components. For clarity, the indices may be dropped.

The S memory sections 420₁ to 420_{S} are similar to the sections 340ⱼ shown in FIG. 3. They are arranged based on the organization scheme illustrated in FIG. 3. Each of the S memory sections 420₁ to 420_{S} has a data transfer circuit 425ⱼ (j = 1, ..., S). For clarity, the index subscript will be dropped. The data transfer circuit 425 is configured to transfer data between a memory cell in the corresponding memory section and a data bus in response to an access operation. It is further described in FIG. 5. The data includes an error-correction code (ECC) embedded in a message data. In one embodiment, the ECC employs the Hamming code. The data may also be distributed over a section set including the memory sections. The term "distributed" here refers to populated or stored in storage locations in a section set as shown in FIG. 3. The access operation may be a write operation or a read operation. The data bus refers to an internal data bus. The memory sections 420₁ to 420_{S} are sections that contain the activated WL segments distributed across the sections.

The address decoder 365 is configured to decode a column address of the access operation to generate a decoded address that enables or selects parts of the data transfer circuit 425. The data transfer circuit 425 will be described further in FIG. 5. The column address CA has W bits: CA_{W},..., CA₁ where CA_{W} is the most significant bit and CA₁ is the least significant bit. It may be considered to include a first part and a second part. The assignment of the address bits to the first part and the second part may be in any order. For illustrative purposes, FIG. 4B shows the first part occupies the lower significant bits and the second part occupies the higher significant bits. The address decoder 365 includes a column select (CS) decoder 412 and an access decoder 414. The CS decoder 412 is configured to decode the first part of the column address CA to generate a CS signal CSⱼ (j=1, ..., V) which enables a select switch in the data transfer circuit 425. The access decoder 414 is configured to decode the second part of the column address and the access signal to generate an access enable signal which enables a data switch in the data transfer circuit 425. The access signal is a WRITE signal or a READ signal. The access decoder 414 generates S write enable signals WR_EN, to WR_ENs and S read enables RD_EN₁ to RD_ENs.

FIG. 4B is a diagram of an example illustrating an address decoding scheme using the address decoder 365 shown in FIG. 3 according to an embodiment. In this example, a column address CA 430 has 7 bits, numbered 1 for the least significant bit to 7 for the most significant bit. As mentioned above, the bit assignment to the first part and the second part may be in any order. For illustrative purposes shown in FIG. 4B, the first part of the CA 430 includes three bits 1, 2, and 3, or CA₁, CA₂, and CA₃, respectively. The second part of the CA 430 includes four bits 4, 5, 6, and 7, or CA₄, CA₅, CA₆, and CA₇, respectively. As another example, the first part of the CA 430 may include three bits 2, 4, and 7, or CA₂, CA₄, and CA₇, respectively; and the second part of the CA 430 may include four bits 1, 3, 5, and 6, or CA₁, CA₃, CA₅, and CA₆, respectively

The decoding scheme uses a set of AND gates. Other schemes may be employed, such as using look up tables, etc. The number of AND gates is the same as the number of the decoded output lines. For a L-bit address, the number of the decoded output lines is 2^{L}. Each of these lines will go to the enable or select control line of the corresponding part of the data transfer circuit. Since only one part is enabled when HIGH, at most one output line is asserted (e.g., HIGH). The AND gates act like a matching circuit that generates a logic HIGH when the input matches the predetermined address.

The CS decoder 412 includes 8 AND gates, such as AND gates 440₁, 440₂, and 440₈. The outputs of the CS decoder 412 are CS₁, CS₂, . . ., CSs. Each of these outputs goes to a corresponding column select circuit. The eight AND gates match the values of the eight combinations of the 3-bit address. For example, the AND gate 440, matches the CA[3:1] = 000, the AND gate 440₂ matches the CA[3:1] = 001, and the AND gate 440s matches the CA[3:1] = 111.

The access decoder 414 includes 32 AND gates divided into two group. One group 431 is for WRITE and one group 433 is for READ. The group 431 has 16 AND gates such as AND gates 450₁, 450₂, and 450₁₆. The input to each AND gate is the second part of the CA 430 and the WRITE signal. The outputs of the WRITE group 431 are WR_EN₁, WR_EN₂, . . ., WR_EN₁₆. Each of these outputs goes to a corresponding data switch in the data transfer circuit 425. The sixteen AND gates in each group match the values of the sixteen combinations of the 4-bit address and the access. For example, for the WRITE group 431, the AND gate 450, matches the CA[7:4] = 0000, the AND gate 450₂ matches the CA[7:4] = 0001, and the AND gate 450₁₆ matches the CA[7:4] = 1111.

There are two distinct memory functions: Connecting to the memory cells via the BLs and routing data according to the access mode. By having two different parts of the column address to select or enable these two different memory functions in the memory sections, the data transfer is efficient and avoids duplications when the ECC is combined with the message to be distributed equally or evenly over the sections having active WLs.

FIG. 5 is a diagram illustrating the data transfer circuit 425 in FIG. 4 having distributed active WLs according to an embodiment. In FIG. 5, for illustrative purposes, only relevant components or subelements are shown. The data transfer circuit 425 includes a matrix 320ₙ and a matrix 320ₘ, and transfer circuits 510ₙ and 510ₘ. The data transfer circuit 425 may include more or less than the above components. The matrix 320ₙ and the matrix 320ₘ are physically separated in the same section 340. The WL, LIO, LIOB, CS, WR_EN, and RD_EN lines or signals associated with the matrices 320ₙ and 320ₘ are also physically separated. The GIO and GIOB, however, are common to both.

The matrix 320 includes the WL circuits including WLᵢ₋₁, WLᵢ, WLᵢ₊₁, and WLᵢ₊₂, ..., and two groups of memory cells. Each of the WLs WLᵢ₋₁, WLᵢ, WLᵢ₊₁, and WLᵢ₊₂, ..., is WL that is connected to memory cells and is activated by an activation signal from the control circuit 230. Each WL is connected to gates of the transistor of the memory cells. When a WL is activated, all transistors of memory cells connected to that WL are turned on. There are two groups of memory cells. The groups of memory cells include the group 520₁ₘ to 520_{Vm} and the group 520₁ₙ to 520_{Vn} where n, and m are indices of groups and subgroups of memory cells in a hierarchical structure of the memory cells. A typical hierarchical structure may include banks, chips, ranks, modules, and channels. Depending on how the structure is partitioned, these indices refer to the indices associated with the underlying hierarchical levels. The use of two groups is for illustrative purposes only.

Each of the memory cells 520₁ₙ to 520_{Vn} and 520₁ₘ to 520_{Vm} includes a transistor and a capacitor that retains a storage charge. During activation, the gates of the transistors associated with the activated WL are turned on, connecting the charges to the corresponding BLs to the transfer circuits.

Each of the transfer circuits 510ₙ and 510ₘ transfers the data represented by the charges to and from the memory cells to the external devices. The indices n and m refer to the hierarchical level of the memory array structure. The two transfer circuits 510ₙ and 510ₘ are similar and therefore it is sufficient to describe one.

The transfer circuit 510ₙ includes V select switches 530₁ₙ...., 530_{Vn} and V select switches 550₁ₙ...., 550_{Vn}, V BLSAs 540₁ₙ to 540_{Vn}, and a data switch 560ₙ. The transfer circuit 510ₙ may include more or less than the above components. Each of the select switches 530₁ₙ...., 530_{Vn} and 550₁ₙ...., 550_{Vn} is a transistor which is configured to connect a local input/output (LIO) line to a bit line (BL) by a corresponding column select (CS) signal. For example, the select switches 530₁ₙ and 550₁ₙ are controlled or enabled by the CS signal CS₁ from the CS decoder 412 in FIG. 4A. The LIO line represents the data line connected to the memory cells. The BL is connected to a corresponding memory cell 520. The bit line and local IO lines carry differential signals representing true signal (BL and LIO) and a complementary signal (BLB and LIOB). The select switches 530₁ₙ...., 530_{Vn} are responsible for connecting the LIO lines to the BL lines. The select switches 550₁ₙ...., 550_{Vn} are responsible for connecting the LIOB lines to the BLB lines. The CS signal is connected to the gate of the select transistors 530 and 550. When it is HIGH, the LIO line is connected to the BL and the LIOB is connected to the BLB. When it is LOW, the connection is off. The transfer circuit 510ₙ is used during access cycles. It may also be used during prefetch operations through the data switch 560ₙ.

Each of the BLSA 540₁ₙ to 540_{Vn} is configured to detect the very small change in voltage on the corresponding BL to read the capacitor's charge and then amplify it to a recognizable logic level. The data switch 560ₙ is configured to route data between the LIO and LIOB lines and GIO and GIOB lines, respectively, based on S control signals (WR_EN₁, RD_EN₁ WR_EN_{S}, RD_EN_{S}) which is obtained from the second part of the column address and the status of the access signals WRITE and READ. The GIO and GIOB lines carry complementary signals to and from the data lines of the memory circuit.

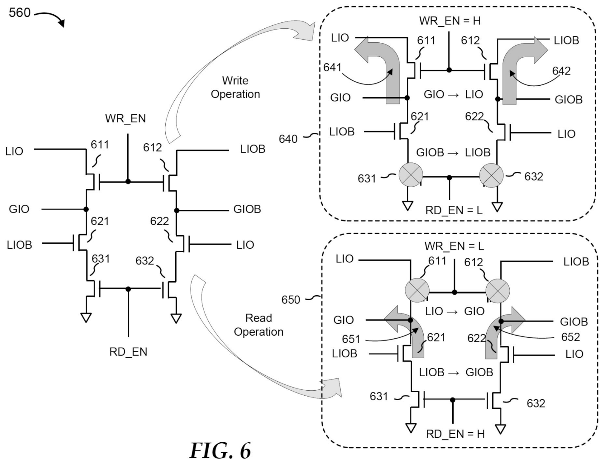

FIG. 6 is a diagram illustrating the data switch 560 in FIG. 5 according to an embodiment. The data switch 560 is connected to the LIO, LIOB, GIO, and GIOB lines shown in FIG. 5. It also receives control signals WR_EN and RD_EN for enabling writing and reading modes, respectively. The data switch includes 6 transistors 611, 612, 621, 622, 631, and 632. For illustrative purposes, the transistors are n-channel metal oxide semiconductors (NMOS) devices.

The transistors 611 and 621 provide bidirectional data flow between LIO and GIO lines. The transistors 612 and 622 provide bidirectional data flow between LIOB and GIOB lines. The transistors 631 and 632 provide termination for the data flow in the read mode. The gates of the transistors 611 and 612 are connected to the WR_EN signal. The gates of the transistors 631 and 632 are connected to the RD_EN signal. One terminal of each of the transistors 631 and 632 is connected to ground. The data switch 560 operates in two main operational modes: a write operation 640 and a read operation 650. It may also be in an idle mode when it's not in a write operation or a read operation.

The write operation 640 illustrated in FIG. 6 shows the data flows when the data switch 560 is in the write operation. The WR_EN is HIGH (H), turning on the transistors 611 and 612. The RD_EN is LOW (L), turning off the transistors 631 and 632. A data flow 641 goes from the GIO line to the LIO line through the transistor 611. The transistor 631 is off, blocking the data flow through the transistor 621. Similarly, a data flow 642 goes from the GIOB line to the LIOB through the transistor 612. The transistor 632 is off, blocking the data flow through the transistor 621. Thus, the write operation is performed by routing the external data on the GIO and GIOB lines to the LIO and LIOB lines, respectively, which in turn are connected to the corresponding BL and BLB lines as selected by the corresponding CS signal and to the memory cell 520 enabled by the activated WL.

The read operation 650 as illustrated in FIG. 6 shows the data flows when the data switch 560 is in the read operation. The RD_EN is HIGH (H), turning on the transistors 631 and 632. The WR_EN is LOW (L), turning off the transistors 611 and 612. A data flow 651 goes from the LIOB line to the GIO line through the transistor 621 by using the line LIOB to control the gate of the transistor 621 The transistor 611 is off, blocking the data flow through it. Similarly, a data flow 652 goes from the LIO line to the GIOB line through the transistor 622 by using the line LIOB to control the gate of the transistor 622. The transistor 612 is off, blocking the data flow through it. Thus, the read operation is performed by routing the data on the LIO and LIOB lines to the GIOB and GIO lines, respectively, which in turn are connected to the data bus of the memory circuit. The memory cell 520 is enabled by the activated WL to transfer the charge to the corresponding BL and BLB lines as selected by the corresponding CS signal.

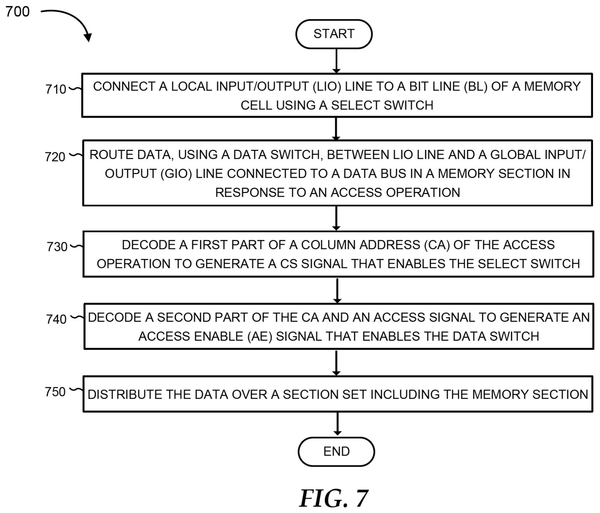

FIG. 7 is a flow chart illustrating a process 700 of accessing a memory circuit with distributed active WLs according to an embodiment. The process 700 includes several steps or processes as described in the following. These steps or processes may be performed in any order and do not have to follow the order as shown. In addition, any of the steps or processes may not be necessary.

The process 700 connects a local input/output (LIO) line to a bit line (BL) of a memory cell using a select switch (process 710). Next, the process 700 routes data, using a data switch, between the LIO line and a global input/output (GIO) line connected to a data bus in a memory section in response to an access operation (process 720). The memory section is selected by an active word line (WL) (process 710). The data includes an error-correction code (ECC) and prefetch data. The access operation includes a write operation and a read operation. Next, the process 700 decodes a first part of a column address (CA) of the access operation to generate a decoded address that enables the data transfer circuit decodes a first part of the column address to generate a CS signal that enables the select switch (process 730). Next, the process 700 decodes a second part of the CA together with an access signal (WRITE or READ) to generate an access enable signal that enable the data switch (process 740). The first part, the second part, and the column address have a first bit width, a second bit width, and an address bit width, respectively. The address bit width is equal to the sum of the first bit width and the second bit width. The process 700 then distributes the data over a section set including the memory section (Process 750). The process is then terminated.

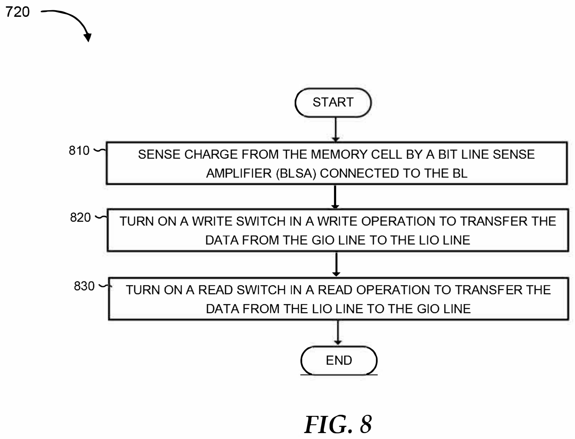

FIG. 8 is a flow chart illustrating the process 720 in FIG. 7 of routing data according to an embodiment.

The process 720 senses charge from the memory cell by a bit line sense amplifier (BLSA) connected to the BL (process 810). Next, the process 720 turns on a write switch in a write operation to transfer the data from the GIO line to the LIO line (process 820). This is illustrated in FIG. 6. The on-switch write signal is the WR_EN signal in FIG. 6. Then, the process 720 turns on a read switch in a read operation to transfer the data from the LIO line to the GIO line (Process 830). The on-switch read signal is the RD_EN signal in FIG. 6. The process 720 is then terminated.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable sub-combination. Moreover, although features may be described above as acting in certain combinations and even initially claimed as such, one or more features from a claimed combination may in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications within the scope of the following claims.

## Claims

1. A device comprising:
a data transfer circuit (425) comprising a select switch (530, 550) configured to connect a local input/output, LIO, line to a bit line, BL, of a memory cell (520) and a data switch (560) configured to route data between the LIO line and a global input/output, GIO, line connected to a data bus in a memory section (340) in response to an access operation;
a column select, CS, decoder (412) configured to decode a first part of a column address, CA, (430) of the access operation to generate a CS signal that enables the select switch; and
an access decoder (414) configured to decode a second part of the CA (430) and an access signal to generate an access enable, AE, signal that enables the data switch (560).

2. The device of claim 1, wherein the access operation includes a write operation and a read operation.

3. The device of claim 1 or 2, wherein the memory section (420) is selected by an active word line, WL, (335).

4. The device of claim 3, wherein the data transfer circuit (425) further comprises:
a bit line sense amplifier, BLSA, (540) connected to the BL to sense charge from the memory cell (520).

5. The device of any one of claims 1 to 4, wherein the data switch (560) comprises:
a write switch configured to turn on in a write operation to transfer the data from the GIO line to the LIO line; and
a read switch configured to turn on in a read operation to transfer the data from the LIO line to the GIO line.

6. The device of any one of claims 1 to 5, wherein the data is distributed over a section set (420₁ to 420_{S}) including the memory section (420).

7. The device of any one of claims 1 to 6, wherein
the first part of the CA (430), the second part of the CA (430), and the CA (430) have a first bit width, a second bit width, and an address bit width, respectively, and
the address bit width is equal to a sum of the first bit width and the second bit width.

8. The device of any one of claims 1 to 7, wherein the data includes an error-correction code, ECC, and prefetch data.

9. The device of any one of claims 1 to 8, wherein each of the LIO, GIO, and BL lines is configured to carry differential signals.

10. The device of any one of claims 1 to 9, wherein, the memory section (420) is on a two-dimensional, 2D, stack in a three-dimensional, 3D, memory circuit (128).

11. A method comprising:
connecting (710) a local input/output, LIO, line to a bit line, BL, of a memory cell (520) using a select switch (530, 550);
routing (720) data, using a data switch (560), between the LIO line and a global input/output, GIO, line connected to a data bus in a memory section (420) in response to an access operation;
decoding (730) a first part of a column address, CA, (430) of the access operation to generate a CS signal that enables the select switch (530, 550); and
decoding (740) a second part of the CA and an access signal to generate an access enable, AE, signal that enables the data switch (560).

12. The method of claim 11, wherein the access operation includes a write operation and a read operation.

13. The method of claim 11 or 12, wherein the memory section (420) is selected by an active word line, WL, (335).

14. The method of any one of claims 11 to 13, wherein routing (720) the data comprises:
sensing (810) charge from the memory cell (520) by a bit line sense amplifier, BLSA, connected to the BL.

15. The method of any one of claims 11 to 14, wherein routing (720) the data comprises:
turning on (820) a write switch in a write operation to transfer the data from the GIO line to the LIO line; and
turning on (830) a read switch in a read operation to transfer the data from the LIO line to the GIO line.
